# EUROPÄISCHE PATENTANMELDUNG

(11) **EP 1 906 377 A1**
(43) Veröffentlichungstag der Anmeldung: **02.04.2008**
(21) Anmeldenummer: 07017047.7
(22) Anmeldetag: 31.08.2007
(51) Int. Cl.: G09B 5/00, G09B 19/00

(54) **System und Verfahren zur Integration eines Prozessleitsystems in einen Trainingssimulator**

(30) Priorität: 27.09.2006 DE 102006045503
(71) Anmelder: ABB Technology AG, 8050 Zurich (CH)
(72) Erfinder: Frick, Alexander, Dr., 69198 Schriesheim (DE)
(74) Vertreter: Miller, Toivo

(57) **Zusammenfassung**

Die Erfindung bezieht sich auf ein System und Verfahren zur Integration eines Prozessleitsystems einer technischen Anlage oder eines technischen Prozesses in einen Trainingssimulator (30), wobei der Trainingssimulator (30) mit einem virtuellen PC (20) zusammenwirkt. Auf dem virtuellen PC (20) ist eine Software zur Nachbildung der technischen Anlage oder des technischen Prozesses und eine Software zur Nachbildung der Bedienoberfläche des Prozessleitsystems (21) abgelegt. Weiterhin ist auf dem virtuellen PC (20) eine weitere Software zur Ausführung von Funktionalitäten für die Simulation (22) vorhanden. Der virtuelle PC (20) wirkt so mit dem Trainingssimulator (30) zusammen, dass die Funktionalitäten für die Simulation mittels des Trainingssimulators (30) ansteuerbar sind.

## Beschreibung

Die Erfindung betrifft ein System und Verfahren zur Integration eines Prozessleitsystems einer technischen Anlage oder eines technischen Prozesses in einen Trainingssimulator gemäß den Ansprüchen 1 und 8 und ist insbesondere für einen Einsatz in der Öl- und Gasindustrie, der chemischen Industrie oder der Energieerzeugung vorgesehen.

Trainingssimulationssysteme werden zur Schulung von Anlagenbedienern eingesetzt, um den Betrieb einer technischen Anlage oder eines technischen Prozesses nachzubilden, ohne dabei die Produktion zu beeinträchtigen bzw. zu gefährden.

Für die Simulation eines technischen Prozesses ist eine Nachbildung des Prozesses notwendig, welche üblicherweise auf einer Originalreplikation der Beobachtungs- und Bedienstation, auch als Bedienerschnittstelle bezeichnet, und der entsprechend hinterlegten Logikfunktionen beruht.

Wichtige Anforderungen, die während der Simulation des technischen Prozesses erforderlich sind, können jedoch von der Bedienerschnittstelle und somit auch von ihrer Originalreplikation nicht bereitgestellt werden.

Gegenwärtig wird deshalb die vorhandene Software der Bedienoberfläche eines Prozessleitsystems um zusätzliche Funktionalitäten erweitert, die für die Simulation eines technischen Prozesses vorgesehen sind. Die zusätzlichen Funktionalitäten sind beispielsweise ein Starten oder Stoppen des technischen Prozesses, ein Zwischenspeichern von momentanen Werten oder Simulationseinstellungen oder eine Software zur Nachbildung der entsprechenden Logikfunktionen, die während der Simulation des technischen Prozesses erforderlich sind.

Entsprechend werden auch die Steuergeräte der Anlage, im folgenden auch als Controller bezeichnet, nachgebildet, wobei den Nachbildungen der Controller ebenfalls die für eine Trainingssimulation benötigten Funktionalitäten fehlen. Somit ist es erforderlich nicht nur die vorhandene Software der Bedienerschnittstelle zu verändern, sondern es muss auch die Software der Controller um zusätzliche Funktionalitäten erweitert werden.

Eine andere Vorgehensweise zur Simulation des technischen Prozesses beruht auf einer kompletten Nachbildung des Automatisierungssystems und der Beobachtungs-und Bedienstation innerhalb eines Prozesssimulators, welche jedoch mit einer zeitaufwendigen und kostenintensiven Programmierung des Prozesssimulators verbunden ist.

Der Erfindung liegt demgemäß die Aufgabe zugrunde, ein System und Verfahren zur Integration eines Prozessleitsystems einer technischen Anlage oder eines technischen Prozesses in einen Trainingssimulator anzugeben, wodurch vorgenannte Nachteile des Standes der Technik überwunden werden.

Diese Aufgabe wird erfindungsgemäß durch ein System mit den in Anspruch 1 angegebenen Merkmalen gelöst. Vorteilhafte Ausgestaltungen, Verbesserungen des erfindungsgemäßen Systems und ein entsprechendes Verfahren zur Integration eines Prozessleitsystems einer technischen Anlage oder eines technischen Prozesses in einen Trainingssimulator sind in weiteren Ansprüchen und in der Beschreibung angegeben.

Erfindungsgemäß umfasst das System zur Integration eines Prozessleitsystems einer technischen Anlage oder eines technischen Prozesses in einen Trainingssimulator einen virtuellen Personal Computer (PC).

Der virtuelle PC ist eine Nachbildung einer Datenverarbeitungseinrichtung und ist als eigenständiges Softwareprogramm in einem Fenster einer Software-Plattform integriert, wobei die Software-Plattform unabhängig von vorhandenen Bedienstationen der technischen Anlage oder des technischen Prozesses sein kann.

Auf dem virtuellen PC sind eine Software zur Nachbildung der technischen Anlage oder des technischen Prozesses als eine Emulation des Prozessleitsystems sowie eine Software zur Nachbildung der Bedienoberfläche des Prozessleitsystems abgelegt.

Desweiteren stellt der virtuelle PC eine weitere Software zur Ausführung von Funktionalitäten für die Simulation bereit. Somit ist der virtuelle PC in der Lage durch ein Zusammenwirken mit dem Trainingssimulator die Funktionalitäten für die Simulation mittels des Trainingssimulators anzusteuern und die Simulation des technischen Prozesses oder der technischen Anlage mittels der auf dem virtuellen PC abgelegten Software auszuführen.

In einer vorteilhaften Ausführungsform des erfindungsgemäßen Systems ist vorgesehen, auf dem virtuellen PC eine Software zur Nachbildung von Controllern der technischen Anlage oder des technischen Prozesses abzulegen, welche ebenfalls für die Simulation des technischen Prozesses oder der technischen Anlage nutzbar ist.

Die für die Simulation vom virtuellen PC bereitgestellten Funktionalitäten sind beispielsweise über eine Schnittstelle so ansteuerbar, dass ein virtuelle Netzwerk, auch als virtueller Server bezeichnet, in vorteilhafter Weise beliebig gestartet, gestoppt werden kann und momentane Werten oder Simulationseinstellungen und/oder Simulationsergebnisse zwischenspeicherbar sind. Das virtuelle Netzwerk, bestehend aus Bedienoberflächen, den sogenannten Server und Clients, und den Nachbildungen des Prozessleitsystems ist somit eine Abbildung der kompletten Netzwerkkonfiguration, die innerhalb eines Leittechnikprojektes direkt virtuell abgebildet wird.

Der virtuelle PC ist in einer weiteren Ausführungsform des erfindungsgemäßem Systems über eine Schnittstelle mit einer Trainerstation, auch als Instruktor bezeichnet, verbunden, so dass eine Anweisung zur Ausführung der jeweils benötigten Funktionalität vom Instruktor an den virtuellen PC über die Schnittstelle bereitstellbar ist.

Die Vorteile der Erfindung beruhen des weiteren darauf, mittels der Verwendung des virtuellen PC's den technischen Prozess oder die technische Anlage und die entsprechenden Funktionen für die Simulation nachzubilden, ohne dazu die Originalsoftware der Bedienoberfläche für das Prozessleitsystem mit zusätzlichen für die Simulation erforderlichen Funktionalitäten zu erweitern.

Auch sind alle Originalfiles und Werkzeuge, welche für die Bedienerschnittstelle und die Controller verwendet werden ohne eine zeitintensive Anpassung verwendbar.

In einer Ausgestaltung des erfindungsgemäßen Systems ist die komplette Netzwerkkonfiguration innerhalb eines Leittechnikprojektes mittels des virtuellen PC's direkt abbildbar und vom Trainingssimulator nutzbar.

Das erfindungsgemäße System ist in vorteilhafter Weise neben der Simulation des Betriebes der technischen Anlage oder des technischen Prozesses auch zur Entwicklung, zum Test und/oder zur Validierung einer Leittechnikkonfiguration sowie zur Überprüfung der Anlagenauslegung vor der Inbetriebnahme der technischen Anlage und/oder zum Test von sicherheitskritischen Anlagenkomponenten vorgesehen.

Das Verfahren mit dem die Aufgabe weiterhin gelöst wird, ist dem Anspruch 8 zu entnehmen. Das erfindungsgemäße Verfahren zur Integration eines Prozessleitsystems einer technischen Anlage oder eines technischen Prozesses in einen Trainingssimulator beruht darauf, dass der Trainingssimulator mit einem virtuellen PC verbunden wird. Auf dem virtuellen PC werden eine Software zur Nachbildung der technischen Anlage oder des technischen Prozesses und eine Software zur Nachbildung der Bedienoberfläche des Prozessleitsystems abgelegt. Weiterhin wird auf dem virtuellen PC eine weitere Software zur Ausführung von Funktionalitäten für die Simulation gespeichert, wobei die im virtuellen PC abgelegten Funktionalitäten für die Simulation mittels des Trainingssimulators angesteuert werden.

Somit werden mittels eines virtuellen PC's in vorteilhafter Weise der technische Prozess oder die technische Anlage und die entsprechenden Funktionen für die Simulation nachgebildet ohne dazu die Software der Bedienoberfläche für das Prozessleitsystem und die Software der Controller mit zusätzlichen für die Simulation erforderlichen Funktionalitäten zu erweitern.

Anhand des in der folgenden Figur dargestellten Ausführungsbeispieles sollen die Erfindung sowie weitere vorteilhafte Ausgestaltungen, Verbesserungen und weitere Vorteile der Erfindung näher erläutert und beschrieben werden.

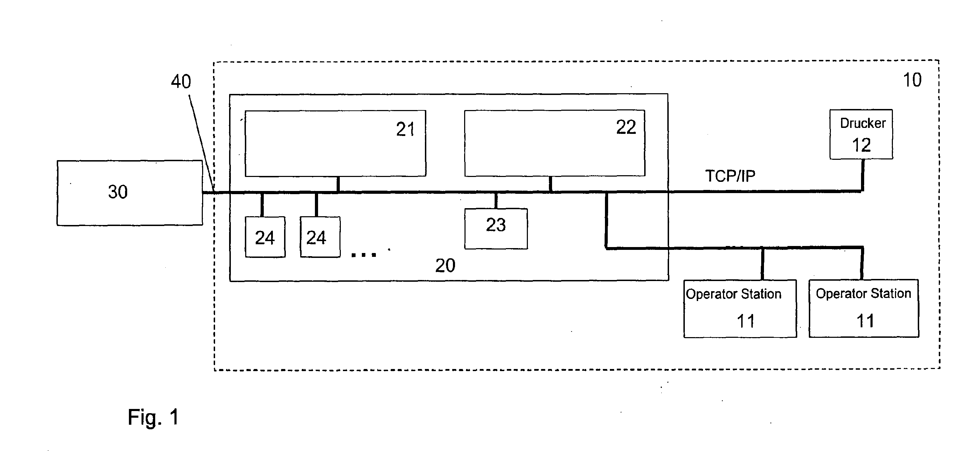

Fig. 1 zeigt eine Ausführungsform des erfindungsgemäßen Systems zur Integration eines Prozessleitsystems in einem Trainingssimulator 30 einer technischen Anlage und umfasst einen Trainingssimulator 30, welcher mit einem virtuellen PC 20 zusammenwirkt.

Der virtuelle PC 20 ist als eigenständiges Softwareprogramm in einem Fenster einer Software-Plattform 10, beispielsweise einer Mensch-Maschine-Schnittstelle, des Prozessleitsystems, welche auch Bedienstationen 11 und Ansteuerungen für externe Hardwaregeräte, wie beispielsweise Drucker umfasst, integriert.

Zur Nachbildung der technischen Anlage für die Simulation sind auf dem virtuellen PC 20 eine Software zur Nachbildung der Bedienoberfläche des Prozessleitsystems 21 und eine weitere Software zur Ausführung von Funktionalitäten für die Simulation 22 abgelegt.

Der virtuelle PC 20 wirkt so mit dem Trainingssimulator 30 zusammen, dass die Funktionalitäten für die Simulation über eine Schnittstelle 40 mittels des Trainingssimulators 30 ansteuerbar sind. Für die Kommunikation des virtuellen PC's 20 mit dem Trainingssimulator 30 wird vorzugsweise das TCP/IP - Protokoll verwendet.

Auf dem virtuellen PC 20 sind weiterhin eine Nachbildung der Controller 23 der technischen Anlage und die entsprechenden Funktionalitäten, die für die Trainingssimulation benötigt werden, abgelegt. Die entsprechenden Funktionalitäten für die Trainingssimulation sind ebenfalls mittels des Trainingssimulators 30 ansteuerbar.

In vorteilhafter Weise werden die Funktionen, welche die Simulation benötigt über eine Internet-Verbindung gestartet und/oder gestoppt.

## Patentansprüche

1. System zur Integration eines Prozessleitsystems einer technischen Anlage oder eines technischen Prozesses in einen Trainingssimulator (30), wobei
- der Trainingssimulator (30) mit einem virtuellen PC (20) zusammenwirkt,
- auf dem virtuellen PC (20) eine Software zur Nachbildung der technischen Anlage oder des technischen Prozesses und eine Software zur Nachbildung der Bedienoberfläche des Prozessleitsystems (21) abgelegt ist,
- auf dem virtuellen PC (20) eine weitere Software zur Ausführung von Funktionalitäten für die Simulation (22) vorhanden ist, und
- der virtuelle PC (20) so mit dem Trainingssimulator (30) zusammenwirkt, dass die Funktionalitäten für die Simulation mittels des Trainingssimulators (30) ansteuerbar sind.

2. System nach Anspruch 1, **dadurch gekennzeichnet, dass** der virtuelle PC (20) eine Nachbildung einer Datenverarbeitungseinrichtung ist und als eigenständiges Softwareprogramm in einem Fenster einer Software-Plattform (10) ausführbar ist.

3. System nach Anspruch 1 oder 2, **dadurch gekennzeichnet, dass** die für die Simulation vom virtuellen PC (20) bereitgestellten Funktionalitäten über eine Schnittstelle (40) ansteuerbar sind.

4. System nach Anspruch 3, **dadurch gekennzeichnet, dass** die weitere Software zur Ausführung von Funktionalitäten für die Simulation (22) von einem Instruktor über die Schnittstelle (40) zum virtuellen PC (20) übertragbar ist.

5. System nach einem der vorherigen Ansprüche, **dadurch gekennzeichnet, dass** auf dem virtuellen PC (20) eine Software zur Nachbildung von Controllern (23) der technischen Anlage oder des technischen Prozesses und die entsprechenden Funktionalitäten für die Simulation abgelegt sind.

6. System nach einem der vorherigen Ansprüche, **dadurch gekennzeichnet, dass** die komplette Netzwerkkonfiguration innerhalb eines Leittechnikprojektes mittels des virtuellen PC's (20) direkt abbildbar und vom Trainingssimulator (30) nutzbar ist.

7. System nach einem der vorherigen Ansprüche, **dadurch gekennzeichnet, dass** neben der Simulation des Betriebes der technischen Anlage oder des technischen Prozesses auch eine Entwicklung, ein Test und/oder eine Validierung einer Leittechnikkonfiguration und/oder eine Überprüfung der Anlagenauslegung vor der Inbetriebnahme und/oder ein Test von sicherheitskritischen Anlagenkomponenten der technischen Anlage vorgesehen ist.

8. Verfahren zur Integration eines Prozessleitsystems einer technischen Anlage oder eines technischen Prozesses in einen Trainingssimulator (30), wobei
- der Trainingssimulator (30) mit einem virtuellen PC (20) verbunden wird,
- auf dem virtuellen PC (20) eine Software zur Nachbildung der technischen Anlage oder des technischen Prozesses und eine Software zur Nachbildung der Bedienoberfläche des Prozessleitsystems (21) abgelegt wird,
- auf dem virtuellen PC (20) weiterhin eine weitere Software zur Ausführung von Funktionalitäten für die Simulation (22) abgelegt wird, und
- die im virtuellen PC (20) abgelegten Funktionalitäten für die Simulation mittels des Trainingssimulators (30) angesteuert werden.

9. Verfahren nach Anspruch 8, **dadurch gekennzeichnet, dass** der virtuelle PC (20) als eigenständiges Softwareprogramm in einem Fenster einer Software-Plattform (10) ausgeführt wird.

10. Verfahren nach einem der Ansprüche 8 oder 9, **dadurch gekennzeichnet, dass** die für die Simulation vom virtuellen PC (20) bereitgestellten Funktionalitäten über eine Schnittstelle (40) angesteuert werden.

11. Verfahren nach Anspruch 10, **dadurch gekennzeichnet, dass** die weitere Software zur Ausführung von Funktionalitäten für die Simulation (22) von einem Instruktor über die Schnittstelle (40) zum virtuellen PC (20) übertragen wird.

12. Verfahren nach einem der Ansprüche 8 bis 11, **dadurch gekennzeichnet, dass** auf dem virtuellen PC (20) eine Software zur Nachbildung von Controllern (23) der technischen Anlage oder des technischen Prozesses und die entsprechenden Funktionalitäten für die Simulation abgelegt werden.

13. Verfahren nach einem der Ansprüche 8 bis 12, **dadurch gekennzeichnet, dass** die komplette Netzwerkkonfiguration innerhalb eines Leittechnikprojektes mittels des virtuellen PC's (20) direkt abgebildet wird und vom Trainingssimulator. (30) genutzt wird.

14. Verfahren nach einem der Ansprüche 8 bis 13, **dadurch gekennzeichnet, dass** neben der Simulation des Betriebes der technischen Anlage oder des technischen Prozesses auch eine Entwicklung, ein Test und/oder eine Validierung einer Leittechnikkonfiguration und/oder eine Überprüfung der Anlagenauslegung vor der Inbetriebnahme und/oder ein Test von sicherheitskritischen Anlagenkomponenten der technischen Anlage durchgeführt wird.
